# EUROPÄISCHE PATENTANMELDUNG

(11) **EP 0 631 145 A2**
(43) Veröffentlichungstag der Anmeldung: **28.12.1994**
(21) Anmeldenummer: 94105934.7
(22) Anmeldetag: 16.04.1994
(51) Int. Cl.: G01R 19/00, H02P 7/00, H02M 7/5387

(54) **Verfahren und Vorrichtung zur Strommessung in Brückenschaltungen**

(30) Priorität: 24.06.1993 DE 4321040
(71) Anmelder: DEUTRONIC ELEKTRONIK GmbH, D-84166 Adlkofen (DE)
(72) Erfinder: Leipold, Michael, D-84036 Landshut (DE); Müller, Wolfgang, D-84155 Bonbruck (DE); Reiner, Alois, D-84166 Adlkofen (DE)
(74) Vertreter: Gustorf, Gerhard, Dipl.-Ing.

(57) **Zusammenfassung**

Bei dem Verfahren zur Strommessung in Brückenschaltungen, insbesondere Vollbrückenschaltungen, werden in einem Brückenzweig zwei getrennte Strommeßeinrichtungen (1, 2) verwendet.

Zur Durchführung des Verfahrens ist eine Vorrichtung vorgesehen, bei der in einem Brückenzweig zwei getrennte Strommeßeinrichtungen (1, 2) so angebracht sind, daß durch ihre Anordnung der durch die Brücke fließende Arbeitsstrom (3, 4) und der gegebenenfalls zirkulierende Freilaufstrom (4, 6) betragsrichtig bewertet wird.

## Beschreibung

Die Erfindung betrifft ein Verfahren und eine Vorrichtung zur Strommessung in Brückenschaltungen. Als Brückenschaltungen kommen insbesondere resonant geschaltete Brücken, d.h. phasenverschobene, unter Nullspannung eingeschaltete Brücken (Phase Shifted PWM-Converter) und konventionelle Pulsbreitenmodulierte Vollbrückenschaltungen in Betracht.

Das Problem des Standes der Technik besteht darin, daß es in Brückenschaltungen durch unsymmetrische Ansteuerung der Brückenzweige zu einer einseitigen gleichstrommäßigen Vormagnetisierung kommen kann.

Der Erfindung liegt die Aufgabe zugrunde, ein System anzugeben, mit dessen Hilfe es möglich ist, den Gleichstromanteil genau zu erfassen, um dadurch die Vollbrücke um den magnetischen Nullpunkt zu betreiben.

Diese Aufgabe wird durch die in den Patentansprüchen angegebenen Merkmale gelöst.

Die Erfassung des Gleichstromanteils ist durch die Art der in der nachstehenden Figurenbeschreibung dargestellten Anordnung der Strommeßeinrichtungen möglich, die im allgemeinen Strommeßtransformatoren sind. Die exakte Erfassung des tatsächlich fließenden Stromes auch im Leichtlastfall und bei Lastsprüngen ist notwendig, um mittels Stromsteuerung (Current Mode Control) jeglicher Art einen symmetrischen Betrieb der Brücke sicherzustellen. Funktionsstörungen bis hin zu Zerstörungen, die durch einseitige Vormagnetisierung des Leistungstransformators bedingt sind, werden sicher unterbunden.

Die Erfindung ist nachstehend an einem Ausführungsbeispiel erläutert, das in der Zeichnung dargestellt ist. Es zeigen:
Figur 1 ein Prinzipschaltbild einer Vollbrückenschaltung eines Transformators mit einer erfindungsgemäß ausgebildeten Strommeßeinrichtung auf der Primärseite in einem ersten Arbeitstakt,
Figur 2 die Vollbrückenschaltung der Figur 1 in der ersten Freilaufphase,
Figur 3 die Vollbrückenschaltung im zweiten Arbeitstakt und
Figur 4 die Vollbrückenschaltung in der zweiten Freilaufphase.

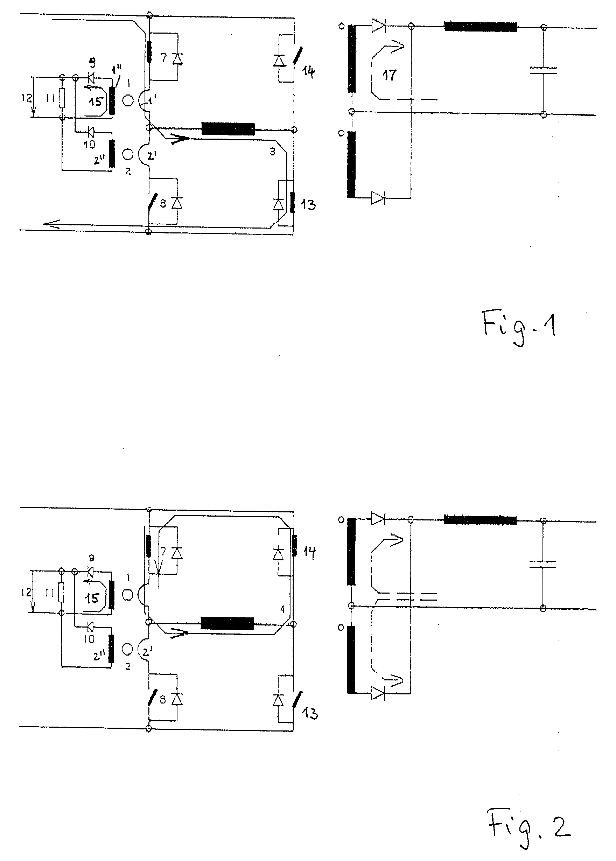

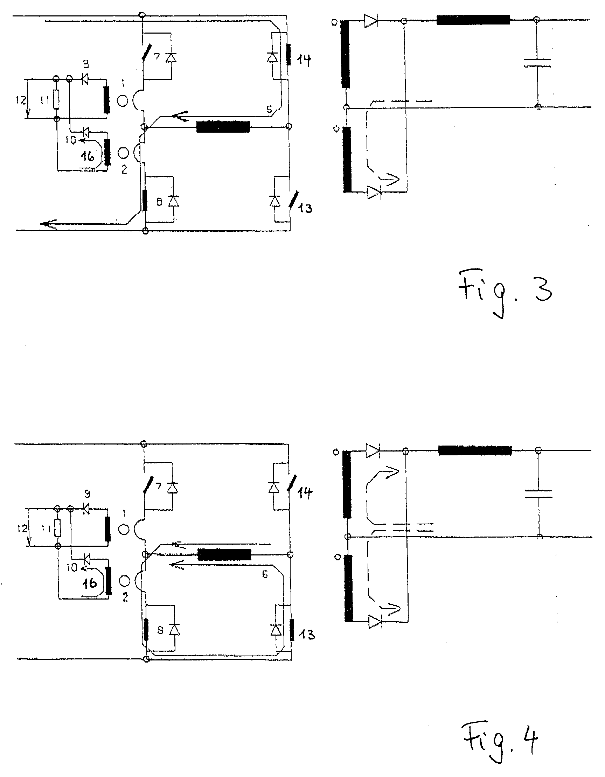

Figur 1 zeigt einen Transformator in einem ersten Arbeitstakt, bei dem auf der Primärseite zwei diagonal gegenüberliegende Schalter 7 und 13 geschlossen sind, während die beiden anderen Schalter 8 und 14 geöffnet sind. Die Schalter sind als Transistoren ausgebildet und können diagonal angesteuert werden. Parallel geschaltete Dioden dienen zur Funktionsdämpfung.

Bei der dem ersten Arbeitstakt entsprechenden Stellung fließt auf der Primärseite ein Arbeitsstrom 3 in der eingezeichneten Richtung, wodurch auf der Sekundärseite ein Strom 17 induziert wird.

Die Primärseite hat in einem Brückenzweig zwei getrennte Strommeßeinrichtungen 1 und 2. Die beiden Kreise der Strommeßeinrichtungen symbolisieren das magnetische Kopfelement, das meistens als Ferritkern ausgebildet ist. Die beiden Strommeßeinrichtungen 1 und 2, die als Strommeßtransformatoren ausgebildet sein können, sind gemäß der Erfindung in den Strompfaden der beiden übereinanderliegenden Leistungsschalter 7 und 8 angeordnet. Dabei ist von jedem der beiden Strompfade eine Wicklung 1' bzw. 2' nach außen geführt und bildet die Primärwicklung, der die jeweilige Meßwicklung 1'' bzw. 2'' gegenüberliegt.

In der Stellung des ersten Arbeitstaktes der Figur 1 fließt in der Meßwicklung 1'' ein Meßstrom 15 in der eingezeichneten Richtung, welcher durch die Diode 9 gleichgerichtet und einem beiden Strompfaden gemeinsamen Bürdenwiderstand 11 zugeführt wird. Es stellt sich dann eine Meßspannung 12 ein, welche das Regelsignal ist, auf das eine Stromsteuerung jeglicher Art (Current Mode Control) arbeitet, z.B. Peak Current Mode Control, Average Current Mode Control und andere.

In der ersten Freilaufphase der Figur 2 sind die einander gegenüberliegenden Schalter 7 und 14 geschlossen, während die Schalter 8 und 13 geöffnet sind. Durch den auf der Primärseite zirkulierenden Freilaufstrom 4 wird auf der Sekundärseite der eingezeichnete Stromfluß induziert.

Figur 3 zeigt den zweiten Arbeitstakt, bei dem die Schalter 7 und 13 geöffnet und die Schalter 8 und 14 geschlossen sind. Dadurch fließt ein Arbeitsstrom 5, der in der Strommeßeinrichtung 2 den Meßstrom 16 erzeugt, welcher wiederum an dem gemeinsamen Bürdenwiderstand 11 eine Strommeßspannung 12 erzeugt.

Figur 4 zeigt die zweite Freilaufphase, bei der die Schalter 7 und 14 geöffnet und die Schalter 8 und 13 geschlossen sind. Der zirkulierende Freilaufstrom 6 kann auch hier betragsrichtig in der Strommeßeinrichtung 2 bewertet werden.

Bei der phasenverschobenen, resonant geschalteten Vollbrücke (Phase Shifted PWM Converter) erfolgt die Anordnung der beiden Strommeßeinrichtungen 1 und 2 bevorzugt in den Strompfaden derjenigen beiden Leistungsschalter 7 und 8, in denen während der Aus-Zeit der Leistungsschalter der Freilaufstrom 4 bzw. 6 der Brückenschaltung zirkuliert. Eine entsprechende Anordnung der Strommeßeinrichtung im entgegengesetzten Brückenzweig ist ebenfalls denkbar.

## Patentansprüche

1. Verfahren zur Strommessung in Brückenschaltungen, insbesondere Vollbrückenschaltungen, dadurch gekennzeichnet, daß in einem Brückenzweig zwei getrennte Strommeßeinrichtungen (1, 2) verwendet werden.

2. Vorrichtung zur Strommessung in Brückenschaltungen, insbesondere Vollbrückenschaltungen, mit Leistungsschaltern, dadurch gekennzeichnet, daß in einem Brückenzweig zwei getrennte Strommeßeinrichtungen (1, 2) so angebracht sind, daß durch ihre Anordnung der durch die Brücke fließende Arbeitsstrom (3, 4) und der gegebenenfalls zirkulierende Freilaufstrom (4, 6) betragsrichtig bewertet wird.

3. Vorrichtung nach Anspruch 2, dadurch gekennzeichnet, daß die Strommeßeinrichtungen (1, 2) in den Strompfaden von zwei übereinanderliegenden Leistungsschaltungen (7, 8) angeordnet sind.

4. Vorrichtung nach Anspruch 2 oder 3, dadurch gekennzeichnet, daß die Strommeßeinrichtungen (1, 2) in den Strompfaden derjenigen Leistungsschalter (7, 8) angeordnet sind, in denen während der Aus-Zeit der Leistungsschalter ein Freilaufstrom (4, 6) der Brückenschaltung zirkuliert.
